# EUROPÄISCHE PATENTSCHRIFT

(11) **EP 3 819 989 B1**
(45) Veröffentlichungstag und Bekanntmachung des Hinweises auf die Patenterteilung: **26.03.2025**
(21) Anmeldenummer: 20203596.0
(22) Anmeldetag: 23.10.2020
(51) Int. Cl.: H01R 12/52, H01R 12/58, H01R 12/62, H01R 12/69, H05K 3/36, H01R 43/20

(54) **ELEKTRISCH LEITENDE VERBINDUNG VON LEITERPLATTEN**
ELECTRICALLY CONDUCTIVE CONNECTION OF PRINTED CIRCUIT BOARDS
RACCORDEMENT ÉLECTROCONDUCTEUR DE CARTES DE CIRCUIT IMPRIMÉ

(30) Priorität: 05.11.2019 DE 102019129714
(43) Veröffentlichungstag der Anmeldung: 12.05.2021
(73) Patentinhaber: Marelli Germany GmbH, 72762 Reutlingen (DE)
(72) Erfinder: Harder, Anna, 72768 Reutlingen (DE)
(74) Vertreter: DREISS Patentanwälte PartG mbB

(56) Entgegenhaltungen:
- EP-A2- 0 664 576
- WO-A1-2010/054924
- DE-A1- 102007 008 109
- DE-A1- 102014 011 704
- DE-A1- 102016 218 788
- DE-A1- 102018 100 557
- JP-A- H08 213 068
- US-A- 3 980 367

## Beschreibung

Die Erfindung betrifft eine elektrisch leitende Kontaktverbindung zwischen einer ersten und einer zweiten Leiterplatte gemäß dem Oberbegriff des Anspruchs 1.

Ferner betrifft die Erfindung ein Verfahren zum Herstellen einer elektrisch leitenden Kontaktverbindung zwischen einer ersten Leiterplatte und einer zweiten Leiterplatte gemäß dem Oberbegriff des Anspruchs 6.

Elektrisch leitende Kontaktverbindungen zwischen Bauteilen, beispielsweise Leiterplatten, sind aus dem Stand der Technik bekannt. Aus der DE 10 2011 119 842 B4 ist ein elektrisches Verbindungselement bekannt, das mehrere aufgelötete Pins umfasst, die in eine Bohrung einer Leiterplatte eingepresst werden können. Gemäß der US 3,980,367 A werden mehrere Leiterplatten mittels eines von geschmolzenem Lot umgebenen Verbinders miteinander verbunden.

Die EP 0 664 576 A2 und DE 10 2018 10 557 A1 beschreiben Leiterplattenanordnungen bei denen ein fester Abstand zwischen starren Leiterplatten durch Anschlussstifte vorgegeben wird.

Die JP H08 213068 A offenbart eine Steckverbindung zwischen einer Leiterplatte und einem flachen elektrischen Anschlusskabel. Die JP H08 213068 A und die DE 10 2014 011704 A1 offenbaren jeweils eine Kontaktverbindung nach dem Oberbegriff des Anspruchs 1.

Ferner ist es beispielsweise bekannt zwei Leiterplatten, insbesondere einer starre und eine flexible Leiterplatte, über sogenannte Steckverbinderleisten und Leiterplattenbuchsen, Stift- oder Buchsenleisten, die auf den Leiterplatten montiert sind, miteinander zu verbinden. Aufgabe der vorliegenden Erfindung ist es eine gegenüber dem Stand der Technik kostengünstigere, mit einem geringeren Aufwand herstellbare, elektrisch leitende Kontaktverbindung und ein Verfahren zum Herstellen der elektrisch leitenden Kontaktverbindung anzugeben. Erfindungsgemäß wird vorgeschlagen, dass der Anschlussstift einen zweiten Abschnitt umfasst, der teilweise in einer, in der zweiten Leiterplatte ausgebildeten, zweiten Öffnung angeordnet ist, wobei der zweite Abschnitt des Anschlussstifts ein Halteelement umfasst, und das Halteelement die zweite Leiterplatte auf einer von der ersten Leiterplatte abgewandten Seite, derart übergreift, dass zwischen der ersten und der zweiten Leiterplatte eine formschlüssige Verbindung ausgebildet ist.

Die erfindungsgemäße Kontaktverbindung ist, ohne einen weiteren Lötvorgang zu erfordern, herstellbar. Im Vergleich zu einer Steckverbindung erfordert die erfindungsgemäße Kontaktverbindung wenig Materialaufwand.

Gemäß der Erfindung ist vorgesehen, dass das Halteelement ein federndes Element umfasst oder als ein federndes Element ausgebildet ist. Das federnde Element kann beispielsweise beim Einführen des zweiten Abschnitts in die zweite Öffnung zusammengedrückt werden, und, anschließend, wenn ein Teil des zweiten Abschnitts auf einer, von der ersten Leiterplatte abgewandten, Seite aus der zweiten Öffnung herausragt, auffedern. Dadurch wird dann das Halteelement ausgebildet, das die zweite Leiterplatte auf der von, der ersten Leiterplatte abgewandten, Seite, derart übergreift, dass dadurch zwischen der ersten und der zweiten Leiterplatte eine formschlüssige Verbindung ausgebildet ist.

Gemäß einer nicht unter den Schutzumfang der Ansprüche fallenden Ausführungsform kann es sich als vorteilhaft erweisen, wenn das Halteelement durch einen plastischen Umformvorgang ausgebildet ist. Der zweite Abschnitt des Anschlussstifts ist wenigstens in einem durch die zweite Öffnung der zweiten Leiterplatte, über die zweite Leiterplatte herausragenden, Abschnitt plastisch verformbar. Das Halteelement ist dann beispielsweise in einem Umformvorgang, insbesondere einem Biegevorgang oder einem Nietvorgang, insbesondere als ein Nietkopf, ausgebildet.

Es kann sich weiter als vorteilhaft erweisen, wenn der erste Abschnitt des Anschlussstifts massiv oder flexibel ausgebildet ist. Wenn der erste Abschnitt massiv ausgebildet ist, handelt es sich um einen nicht kompressiblen Einpresskontakt. Hierbei wird die erste Leiterplatte im Bereich der ersten Öffnung deformiert. Ist der erste Abschnitt flexibel ausgebildet, wird der Anschlussstift durch beim Einführen in die erste Öffnung im Bereich des ersten Abschnitts durch Kontakt mit der ersten Öffnung zusammengedrückt und dadurch eine Vorspannung erzeugt.

Vorteilhafterweise umfasst eine Innenwandung der ersten Öffnung der ersten Leiterplatte und/oder eine Innenwandung der zweiten Öffnung der zweiten Leiterplatte ein elektrisch leitfähiges Material. Die Innenwandung der ersten Öffnung der ersten Leiterplatte und/oder die Innenwandung der zweiten Öffnung der zweiten Leiterplatte sind mit Leiterbahnen der ersten oder der zweiten Leiterplatte elektrisch verbunden. Der Anschlussstift kontaktiert die Innenwandungen der ersten und/oder zweiten Öffnung zumindest teilweise, vorzugsweise vollumfänglich, so dass dadurch eine elektrisch leitende Verbindung ausgebildet ist.

Vorteilhafterweise ist der Anschlussstift wenigstens teilweise aus einem elektrisch leitfähigen Material ausgebildet. Der Anschlussstift ist beispielsweise aus Metall und/oder einer Legierung und/oder teilweise aus Kunststoff in Kombination mit einem elektrisch leitfähigen Material hergestellt.

Es kann sich als vorteilhaft erweisen, wenn die erste und die zweite Öffnung voneinander verschiedene Durchmesser umfassen. Dies kann sich insbesondere beim Herstellen der elektrisch leitenden Kontaktverbindung als vorteilhaft erweisen. So kann beispielsweise der erste Abschnitt des Anschlussstifts der ersten Öffnung, und somit der ersten Leiterplatte, und der zweite Abschnitt des Anschlussstifts der zweiten Öffnung, und somit der zweiten Leiterplatte, zugeordnet werden.

Erfindungsgemäß ist die erste Leiterplatte eine starre Leiterplatte und die zweite Leiterplatte ist eine flexible Leiterplatte. Die erste Leiterplatte umfasst beispielsweise als nichtleitendes Trägermaterial eine mit Epoxidharz getränkte Glasfasermatte, auch unter der Materialkennung FR4 bekannt. Die zweite Leiterplatte ist beispielsweise eine, insbesondere dünne, Leiterplatte auf Basis von Polyimid-Folien. Solche Leiterplatten können vorteilhafterweise platzsparend, insbesondere durch Falten oder Biegen in engsten Strukturen, beispielsweise in Beleuchtungseinrichtungen, und/oder zum Verbinden von zwei starren Leiterplatten, beispielsweise in

Beleuchtungseinrichtungen, verwendet werden. Weitere bevorzugte Ausführungsformen beziehen sich auf ein Verfahren zum Herstellen einer elektrisch leitenden Kontaktverbindung zwischen einer ersten Leiterplatte und einer zweiten Leiterplatte mittels eines Anschlussstifts, wobei die erste Leiterplatte im Bereich der Kontaktverbindung eine erste Öffnung und die zweite Leiterplatte im Bereich der Kontaktverbindung eine zweite Öffnung umfasst, wobei ein erster Abschnitt des Anschlussstifts in die erste Öffnung der ersten Leiterplatte eingepresst wird, und anschließend ein zweiter Abschnitt des Anschlussstifts derart in der zweiten Öffnung der zweiten Leiterplatte angeordnet wird, dass ein Teil des zweiten Abschnitts auf einer von der ersten Leiterplatte abgewandten Seite der zweiten Leiterplatte aus der zweiten Öffnung herausragt und in einem weiteren Schritt in dem herausragenden Teil ein Halteelement ausgebildet wird, das die zweite Leiterplatte derart übergreift, dass zwischen der ersten und der zweiten Leiterplatte eine formschlüssige Verbindung ausgebildet wird. Das Halteelement umfasst ein federndes Element oder ist als ein federndes Element ausgebildet.

Ausführungsbeispiele der Erfindung sind in der Zeichnung dargestellt und werden in der nachfolgenden Beschreibung näher erläutert. Dabei bezeichnen gleiche Bezugszeichen in verschiedenen Figuren jeweils gleiche oder zumindest ihrer Funktion nach vergleichbare Elemente. Es zeigen, jeweils in schematischer Form:
- Fig. 1: eine elektrisch leitende Kontaktverbindung gemäß einer nicht unter den Schutzumfang der Ansprüche fallenden Ausführungsform;
- Fig. 2: eine erfindungsgemäße elektrisch leitende Kontaktverbindung gemäß einer bevorzugten Ausführungsform;
- Fig. 3: einen Anschlussstift einer elektrisch leitenden Kontaktverbindung gemäß einer nicht unter den Schutzumfang der Ansprüche fallenden Ausführungsform;
- Fig. 4: einen Anschlussstift einer erfindungsgemäßen elektrisch leitenden Kontaktverbindung gemäß einer bevorzugten Ausführungsform, und
- Fig. 5: mit erfindungsgemäßen Kontaktverbindungen miteinander verbundene Leiterplatten.

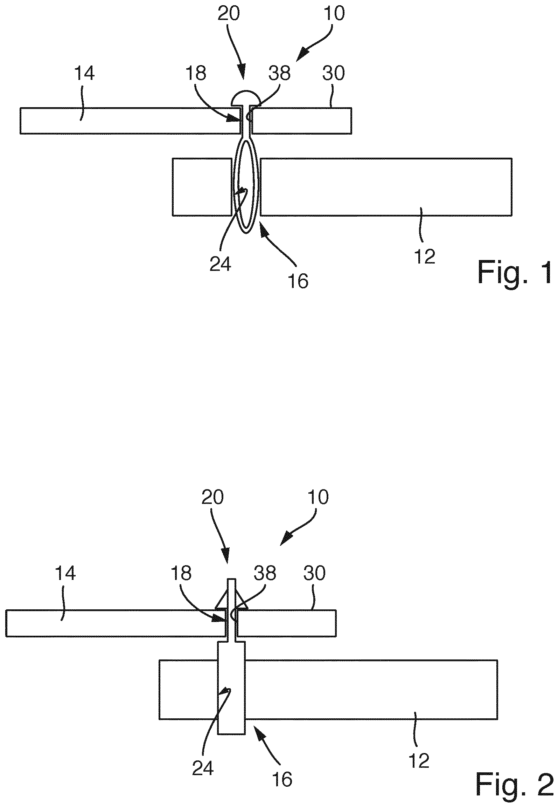

Fig. 1 zeigt eine elektrisch leitende Kontaktverbindung gemäß einer nicht unter den Schutzumfang der Ansprüche fallenden Ausführungsform in einer Schnittansicht, die in ihrer Gesamtheit mit dem Bezugszeichen 10 bezeichnet ist. Die Kontaktverbindung 10 verbindet eine erste Leiterplatte 12 mit einer zweiten Leiterplatte 14.

In der ersten Leiterplatte 12 ist eine erste Öffnung 16 und der zweiten Leiterplatte ist eine zweite Öffnung 18 ausgebildet.

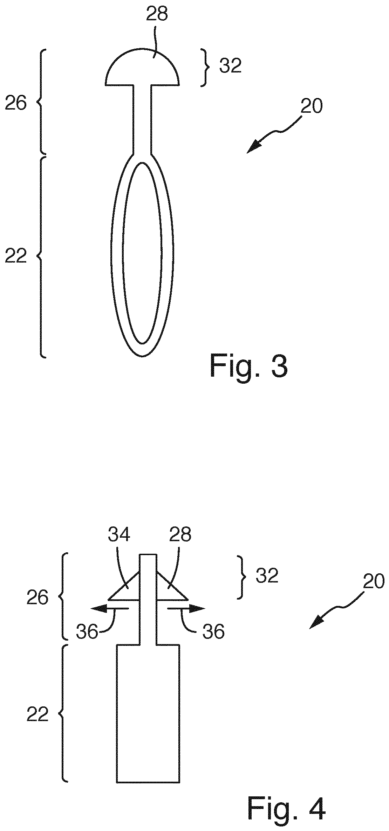

Die Kontaktverbindung 10 umfasst weiter einen Anschlussstift 20. Der Anschlussstift 20 kann beispielswiese auch als Pressfit-Pin bezeichnet werden. Der Anschlussstift 20 ist in einer schematischen Schnittansicht in Fig. 3 dargestellt. Der Anschlussstift 20 umfasst einen ersten Abschnitt 22. Gemäß der in Figuren 1 und 3 dargestellten Ausführungsform ist der erste Abschnitt 22 flexibel ausgebildet. Der erste Abschnitt 22 wird beim Einführen in die erste Öffnung 18 der ersten Leiterplatte 14 durch Kontakt mit einer Innenwandung 24 der ersten Öffnung 18 zusammengedrückt, sodass dadurch eine Vorspannung erzeugt wird und der erste Abschnitt 22 in der ersten Öffnung 16 gehalten wird. Durch den in der ersten Öffnung 16 angeordneten Abschnitt 22 wird also eine Presspassung gebildet.

Der Anschlussstift 20 umfasst weiter einen zweiten Abschnitt 26, der zum Herstellen der elektrischen leitenden Kontaktverbindung 10 teilweise in der zweiten Öffnung 18 der zweiten Leiterplatte 14 angeordnet ist. Der zweite Abschnitt 26 des Anschlussstifts 22 umfasst ein Halteelement 28. Das Halteelement 28 übergreift die zweite Leiterplatte 14 auf einer, von der ersten Leiterplatte abgewandten, Seite 30, derart, dass dadurch zwischen der ersten und der zweiten Leiterplatte 12, 14 eine formschlüssige Verbindung ausgebildet ist.

Das Halteelement 28 ist gemäß der in Figuren 1 und 3 dargestellten Ausführungsform durch einen plastischen Umformvorgang ausgebildet. Der zweite Abschnitt 26 des Anschlussstifts 20 ist wenigstens in einem durch die zweite Öffnung der zweiten Leiterplatte, über die zweite Leiterplatte herausragenden, Teil 32 plastisch verformbar. Das Halteelement 28 ist dann beispielsweise in einem Umformvorgang, insbesondere einem Biegevorgang oder einem Nietvorgang, insbesondere als ein Nietkopf, ausgebildet. Das Umformen erfolgt unter Krafteinwirkung mittels einem geeigneten Werkzeug. Das Umformen umfasst beispielsweise ein sogenanntes Anstauchen des Anschlussstifts 20 und/oder das Vorformen des Teils 32 des zweiten Abschnitts 26 in Form eines Nietkopfs, insbesondere durch kreisende Schläge mit dem Kugelkopfhammer, und/oder das endgültige Formen des Teils 32 des zweiten Abschnitts 26 in Form eines Nietkopfs, insbesondere mittels eines Nietkopfsetzers.

Gemäß den in Figuren 2 und 4 dargestellten Ausführungsformen nach dieser Erfindung ist das Halteelement 28 ein federndes Element 34. Das federnde Element 34 wird beim Einführen des zweiten Abschnitts 26 in die zweite Öffnung 18 entgegen der Richtung der Pfeile 36 zusammengedrückt und federt anschließend, wenn der Teil 32 des zweiten Abschnitts 26 auf der, von der ersten Leiterplatte 12 abgewandten, Seite 30 aus der zweiten Öffnung 18 herausragt, in Richtung der Pfeile 36 auf. Dadurch wird dann das Halteelement 28 ausgebildet, das die zweite Leiterplatte 14 auf der von, der ersten Leiterplatte abgewandten, Seite 30, derart übergreift, dass dadurch zwischen der ersten und der zweiten Leiterplatte 12, 14 eine formschlüssige Verbindung ausgebildet ist.

Ferner ist der erste Abschnitt 22 des Anschlussstifts 20 gemäß den in Figuren 2 und 4 dargestellten Ausführungsformen massiv ausgebildet. Beim Einführen des ersten Abschnitts 22 in die erste Öffnung 16 wird die erste Leiterplatte 12 im Bereich der ersten Öffnung 16 deformiert. Dies wird auch als nichtkompressibler Einpresskontakt bezeichnet.

Der Anschlussstift 20 kann auch weitere nicht dargestellte Kombinationen aus dem ersten und zweiten Abschnitt 22, 26 umfassen. Beispielsweise kann ein massiver erster Abschnitt 22 mit einem deformierbaren zweiten Abschnitt 26 und ein flexibler erster Abschnitt 22 mit einem zweiten Abschnitt 26 mit einem federnden Halteelement 32 kombiniert werden.

Die Innenwandung 24 der ersten Öffnung 16 der ersten Leiterplatte 12 und eine Innenwandung 38 der zweiten Öffnung 18 der zweiten Leiterplatte 14 umfassen ein elektrisch leitfähiges Material. Der Anschlussstift 20 ist wenigstens teilweise aus einem elektrisch leitfähigen Material ausgebildet. Der Anschlussstift 20 ist beispielsweise aus Metall und/oder einer Legierung und/oder teilweise aus Kunststoff in Kombination mit einem elektrisch leitfähigen Material hergestellt. Der Anschlussstift 20 kontaktiert die Innenwandungen 24, 38 der ersten und/oder zweiten Öffnung 16, 18 zumindest teilweise, vorzugsweise vollumfänglich, so dass dadurch eine elektrisch leitende Verbindung zwischen der ersten Leiterplatte 12 und der zweiten Leiterplatte 14 ausgebildet ist.

Gemäß den dargestellten Ausführungsformen umfassen die erste und die zweite Öffnung 16, 18 voneinander verschiedene Durchmesser. Dies kann sich insbesondere beim Herstellen der elektrisch leitenden Kontaktverbindung 10 als vorteilhaft erweisen. So kann beispielsweise der erste Abschnitt 22 des Anschlussstifts 20 der ersten Öffnung 16 und der zweite Abschnitt 26 des Anschlussstifts 20 der zweiten Öffnung 18 zugeordnet werden.

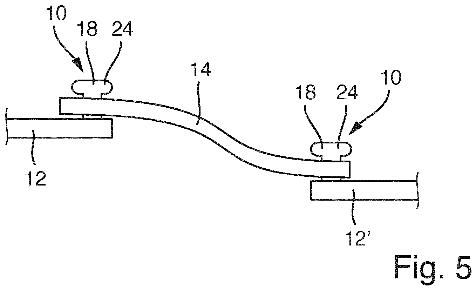

Figur 5 zeigt mehrere mit erfindungsgemäßen Kontaktverbindungen 10 miteinander verbundene Leiterplatten 12, 14 in einer Ansicht von der Seite. Die erste Leiterplatte 12 eine starre Leiterplatte und die zweite Leiterplatte 14 ist eine flexible Leiterplatte. Ferner ist eine weitere, starre Leiterplatte 12' vorgesehen. Die erste Leiterplatte 12 umfasst beispielsweise als nichtleitendes Trägermaterial eine mit Epoxidharz getränkte Glasfasermatte, welches auch unter der Materialkennung FR4 bekannt ist. Die zweite Leiterplatte 14 ist beispielsweise eine, insbesondere dünne, Leiterplatte auf Basis von Polyimid-Folien. Gemäß der dargestellten Ausführungsform ist die zweite Leiterplatte 14 zum Verbinden der zwei starren Leiterplatten 12, 12', vorgesehen. Eine solche Verwendung ist beispielsweise in Beleuchtungseinrichtungen, insbesondere zum Verbinden von LED-Leiterplatten, denkbar. Eine LED-Leiterplatte umfasst dabei eine oder mehrere LEDs, wobei mehrere Leiterplatten insbesondere bei Beleuchtungseinrichtungen mit Mehrkammerreflektoren oder/oder mit mehreren Einspeisepunkten verwendet werden.

## Patentansprüche

1. Elektrisch leitende Kontaktverbindung (10) zwischen einer ersten und einer zweiten Leiterplatte (12, 14), umfassend die erste und die zweite Leiterplatte (12, 14) und einen Anschlussstift (20), wobei der Anschlussstift (20) einen ersten Abschnitt (22) umfasst, der zumindest teilweise in einer, in der ersten Leiterplatte (12) ausgebildeten, ersten Öffnung (16) eine Presspassung bildend angeordnet ist, wobei der Anschlussstift (20) einen zweiten Abschnitt (26) umfasst, der teilweise in einer, in der zweiten Leiterplatte (14) ausgebildeten, zweiten Öffnung (18) angeordnet ist, wobei der zweite Abschnitt (26) des Anschlussstifts (20) ein Halteelement (28) umfasst, und das Halteelement (28) die zweite Leiterplatte (14) auf einer von der ersten Leiterplatte (12) abgewandten Seite (30) der zweiten Leiterplatte (14) derart übergreift, dass zwischen der ersten und der zweiten Leiterplatte (12, 14) eine formschlüssige Verbindung ausgebildet ist, wobei die erste Leiterplatte (12) eine starre Leiterplatte (12) und die zweite Leiterplatte (14) eine flexible Leiterplatte (14) ist, **dadurch gekennzeichnet, dass** das Halteelement (28) zum Herstellen der formschlüssigen Verbindung zwischen der ersten und der zweiten Leiterplatte (12, 14) ein federndes Element (34) umfasst oder als ein federndes Element (34) ausgebildet ist.

2. Kontaktverbindung (10) nach Anspruch 1, **dadurch gekennzeichnet, dass** der erste Abschnitt (22) des Anschlussstifts (20) massiv oder flexibel ausgebildet ist.

3. Kontaktverbindung (10) nach einem oder mehreren der vorhergehenden Ansprüche, **dadurch gekennzeichnet, dass** eine Innenwandung (24) der ersten Öffnung (16) der ersten Leiterplatte (12) und/oder eine Innenwandung (38) der zweiten Öffnung (18) der zweiten Leiterplatte (14) ein elektrisch leitfähiges Material umfasst.

4. Kontaktverbindung (10) nach einem oder mehreren der vorhergehenden Ansprüche, **dadurch gekennzeichnet, dass** der Anschlussstift (20) wenigstens teilweise aus einem elektrisch leitfähigen Material ausgebildet ist

5. Kontaktverbindung (10) nach einem oder mehreren der vorhergehenden Ansprüche, **dadurch gekennzeichnet, dass** die erste und die zweite Öffnung (16, 18) voneinander verschiedene Durchmesser umfassen.

6. Verfahren zum Herstellen einer elektrisch leitenden Kontaktverbindung (10) zwischen einer ersten, starren Leiterplatte (12) und einer zweiten, flexiblen Leiterplatte (14) mittels eine Anschlussstifts (20), wobei die erste Leiterplatte (12) im Bereich der Kontaktverbindung (10) eine erste Öffnung (16) und die zweite Leiterplatte (14) im Bereich der Kontaktverbindung (10) eine zweite Öffnung (18) umfasst, wobei ein erster Abschnitt (22) des Anschlussstifts (20) in die erste Öffnung (16) der ersten Leiterplatte (14) eingepresst wird, und anschließend ein zweiter Abschnitt (26) des Anschlussstifts (20) derart in der zweiten Öffnung (18) der zweiten Leiterplatte (14) angeordnet wird, dass ein Teil (32) des zweiten Abschnitts (26) auf einer von der ersten Leiterplatte (12) abgewandten Seite (30) der zweiten Leiterplatte (14) aus der zweiten Öffnung (18) herausragt und in einem weiteren Schritt in dem herausragenden Teil (32) ein Halteelement (28) ausgebildet wird, das die zweite Leiterplatte (14) derart übergreift, dass zwischen der ersten und der zweiten Leiterplatte (12, 14) eine formschlüssige Verbindung ausgebildet wird, **dadurch gekennzeichnet, dass** das Halteelement (28) zum Herstellen der formschlüssigen Verbindung zwischen der ersten und der zweiten Leiterplatte (12, 14) ein federndes Element (34) umfasst oder als ein federndes Element (34) ausgebildet ist.

## Claims

1. Electrically conductive contact connection (10) between a first and a second circuit board (12, 14), comprising the first and the second circuit board (12, 14) and a connection pin (20), the connection pin (20) comprising a first portion (22) which is at least partially arranged in a first opening (16), formed in the first circuit board (12), to form a press fit, the connection pin (20) comprising a second portion (26) which is partially arranged in a second opening (18) formed in the second circuit board (14), the second portion (26) of the connection pin (20) comprising a holding element (28), and the holding element (28) engaging over the second circuit board (14) on a side (30) of the second circuit board (14) facing away from the first circuit board (12) in such a way that an interlocking connection is formed between the first and the second circuit board (12, 14), the first circuit board (12) being a rigid circuit board (12) and the second circuit board (14) being a flexible circuit board (14), **characterized in that** the holding element (28), for establishing the interlocking connection between the first and the second circuit board (12, 14), comprises a resilient element (34) or is designed as a resilient element (34).

2. Contact connection (10) according to claim 1, **characterized in that** the first portion (22) of the connection pin (20) is solid or flexible.

3. Contact connection (10) according to one or more of the preceding claims, **characterized in that** an inner wall (24) of the first opening (16) of the first circuit board (12) and/or an inner wall (38) of the second opening (18) of the second circuit board (14) comprises an electrically conductive material.

4. Contact connection (10) according to one or more of the preceding claims, **characterized in that** the connection pin (20) is at least partially made of an electrically conductive material.

5. Contact connection (10) according to one or more of the preceding claims, **characterized in that** the first and the second opening (16, 18) have differing diameters.

6. Method for establishing an electrically conductive contact connection (10) between a first, rigid circuit board (12) and a second, flexible circuit board (14) by means of a connection pin (20), the first circuit board (12) comprising a first opening (16) in the region of the contact connection (10) and the second circuit board (14) comprising a second opening (18) in the region of the contact connection (10), a first portion (22) of the connection pin (20) being pressed into the first opening (16) of the first circuit board (14), and then a second portion (26) of the connection pin (20) being arranged in the second opening (18) of the second circuit board (14) in such a way that a part (32) of the second portion (26) protrudes from the second opening (18) on a side (30) of the second circuit board (14) facing away from the first circuit board (12), and in a further step, a holding element (28) being formed in the protruding part (32), which holding element engages over the second circuit board (14) in such a way that an interlocking connection is formed between the first and the second circuit board (12, 14), **characterized in that** the holding element (28), for establishing the interlocking connection between the first and the second circuit board (12, 14), comprises a resilient element (34) or is designed as a resilient element (34).

## Revendications

1. Connexion à contact (10) électriquement conductrice entre une première et une seconde carte de circuit imprimé (12, 14), comprenant la première et la seconde carte de circuit imprimé (12, 14) et une broche de connexion (20), dans laquelle la broche de connexion (20) comprend une première section (22) qui est au moins partiellement disposée dans une première ouverture (16) réalisée dans la première carte de circuit imprimé (12) de manière à former un ajustement serré, dans laquelle la broche de connexion (20) comprend une seconde section (26) qui est partiellement disposée dans une seconde ouverture (18) réalisée dans la seconde carte de circuit imprimé (14), dans laquelle la seconde section (26) de la broche de connexion (20) comprend un élément de maintien (28), et l'élément de maintien (28) recouvre la seconde carte de circuit imprimé (14) sur un côté (30) de la seconde carte de circuit imprimé (14) qui est opposé à la première carte de circuit imprimé (12) de telle sorte qu'une liaison par complémentarité de forme est réalisée entre la première et la seconde carte de circuit imprimé (12, 14), dans laquelle la première carte de circuit imprimé (12) est une carte de circuit imprimé rigide (12) et la seconde carte de circuit imprimé (14) est une carte de circuit imprimé flexible (14), **caractérisée en ce que** l'élément de maintien (28) comprend un élément élastique (34) ou est réalisé sous forme d'élément élastique (34) pour permettre d'établir la liaison par complémentarité de forme entre la première et la seconde carte de circuit imprimé (12, 14).

2. Connexion à contact (10) selon la revendication 1, **caractérisée en ce que** la première section (22) de la broche de connexion (20) est réalisée de manière solide ou flexible.

3. Connexion à contact (10) selon l'une ou plusieurs des revendications précédentes, **caractérisée en ce qu'**une paroi interne (24) de la première ouverture (16) de la première carte de circuit imprimé (12) et/ou une paroi interne (38) de la seconde ouverture (18) de la seconde carte de circuit imprimé (14) comprennent un matériau électriquement conducteur.

4. Connexion à contact (10) selon l'une ou plusieurs des revendications précédentes, **caractérisée en ce que** la broche de connexion (20) est réalisée au moins partiellement à partir d'un matériau électriquement conducteur.

5. Connexion à contact (10) selon l'une ou plusieurs des revendications précédentes, **caractérisée en ce que** la première et la seconde ouverture (16, 18) comprennent des diamètres différents l'un de l'autre.

6. Procédé de fabrication d'une connexion à contact (10) électriquement conductrice entre une première carte de circuit imprimé rigide (12) et une seconde carte de circuit imprimé flexible (14) au moyen d'une broche de connexion (20), dans lequel la première carte de circuit imprimé (12) comprend une première ouverture (16) dans la zone de la connexion à contact (10) et la seconde carte de circuit imprimé (14) comprend une seconde ouverture (18) dans la zone de la connexion à contact (10), dans lequel une première section (22) de la broche de connexion (20) est enfoncée dans la première ouverture (16) de la première carte de circuit imprimé (14), et une seconde section (26) de la broche de connexion (20) est ensuite disposée dans la seconde ouverture (18) de la seconde carte de circuit imprimé (14) de telle sorte qu'une partie (32) de la seconde section (26) fait saillie hors de la seconde ouverture (18) sur un côté (30) de la seconde carte de circuit imprimé (14) qui est opposé à la première carte de circuit imprimé (12) et que, dans une autre étape, un élément de maintien (28) est réalisé dans la partie (32) faisant saillie, lequel élément de maintien recouvre la seconde carte de circuit imprimé (14) de telle sorte qu'une liaison par complémentarité de forme est réalisée entre la première et la seconde carte de circuit imprimé (12, 14), **caractérisé en ce que** l'élément de maintien (28) comprend un élément élastique (34) ou est réalisé sous forme d'élément élastique (34) pour permettre d'établir la liaison par complémentarité de forme entre la première et la seconde carte de circuit imprimé (12, 14).
